# EUROPÄISCHE PATENTANMELDUNG

(11) **EP 0 762 540 A1**
(43) Veröffentlichungstag der Anmeldung: **12.03.1997**
(21) Anmeldenummer: 96110621.8
(22) Anmeldetag: 01.07.1996
(51) Int. Cl.: H01Q 17/00, E04B 9/24, E04F 13/08

(54) **EMV-Messraum**

(30) Priorität: 11.09.1995 DE 29514572 U
(71) Anmelder: SIEMENS MATSUSHITA COMPONENTS GmbH & CO KG, 81541 München (DE)
(72) Erfinder: Feth, Josef, 89522 Heidenheim (DE); Simonelli, Alberto, 89537 Giengen (DE)
(74) Vertreter: Fuchs, Franz-Josef, Dr.-Ing.

(57) **Zusammenfassung**

Bei einem EMV-Meßraum werden Absorberplatten auf einer Unterkonstruktion gehaltert. Die Absorberplatten weisen zentrale Befestigungslöcher auf, in denen Kunststoffteile (1) angeordnet sind, wobei die Kunststoffteile (1) derart ausgebildet sind, daß der Kopf der Befestigungsschraube in der jeweiligen Absorberplatte versenkt ist.

## Beschreibung

Die Erfindung betrifft einen EMV-Meßraum, der mit auf einer Unterkonstruktion befestigten Absorberplatten ausgestattet ist, und bei dem die Absorberplatten zumindest ein zentrales Befestigungsloch aufweisen und durch ein Befestigungsmittel lösbar mit der Unterkonstruktion verbunden sind.

Ein derartiger EMV-Meßraum ist aus der DE 43 27 284 A1 bekannt.

Dort ist als Befestigungsmittel ein selbstsichernder Dübel vorgesehen, der lösbar mit der Unterkonstruktion verbunden ist.

Messungen der Störaussendung und der Störfestigkeit an Prüflingen werden in geschirmten Räumen durchgeführt. Zur Vermeidung von Reflexion und Raumresonanzen des geschirmten Raumes ist es notwendig, diesen mit Absorbern auszukleiden. Hierbei können Pyramidenabsorber oder auch Ferritabsorber eingesetzt werden.

Da es genormte Raumgrößen nicht gibt, sondern die Größe eines Raumes in Breite, Tiefe und Höhe in verschiedenen Gebäuden unterschiedlich ist, wird die Auskleidung derartiger, zur Abschirmung vorgesehener Räume durch individuell angepaßte Montage auf der Baustelle durchgeführt.

Falls bei dieser Auskleidung die Absorberplatten entweder auf eine Unterkonstruktion oder auch direkt auf Einzelschirmungsmodule aufgeklebt werden, ist es später nur noch unter unverhältnismäßig großem Aufwand möglich, einzelne Absorberplatten auszutauschen.

Weiterhin ist es aus der DE 42 25 912 A1 bekannt, die Absorberplatten auf einer Trägerplatte anzuordnen und diese Trägerplatte in einer Unterkonstruktion einzuhängen oder aufzuschrauben. Die Größe dieser Trägerplatte richtet sich nach dem Gesamtgewicht und beträgt beispielsweise 600 x 600 mm².

Beim eingangs angeführten Stand der Technik werden die einzelnen Absorberplatten nur durch die selbstsichernden Dübel gehalten, was - insbesondere bei öfterem Austauschen - nicht immer zu einer sicheren Befestigung führt.

Aufgabe der vorliegenden Erfindung ist es, den eingangs genannten EMV-Meßraum derart weiterzugestalten, daß eine wirtschaftliche, sichere und lösbare Verbindung zwischen den Absorberplatten und der Unterkonstruktion hergestellt wird.

Diese Aufgabe wird erfindungsgemäß dadurch gelöst, daß in den Befestigungslöchern Kunststoffteile angeordnet sind, in welchen jeweils eine Befestigungsschraube geführt ist, deren Kopf im Loch der Absorberplatten versenkt wird.

Vorzugsweise werden die Absorberplatten dabei durch selbstschneidende Befestigungsschrauben gehalten.

Durch die Ausgestaltung ergibt sich der Vorteil, daß die Reflexionsfläche durch den versenkten Schraubenkopf gering gehalten ist.

Weiterhin ist es möglich, das Kunststoffteil als Klemmdübel derart auszubilden, daß weder Kunststoffteil noch Schraubenkopf auf der jeweiligen Absorberplatte aufliegen, sondern im Loch der Absorberplatte versenkt sind.

Die Erfindung wird anhand der folgenden Ausführungsbeispiele näher erläutert.

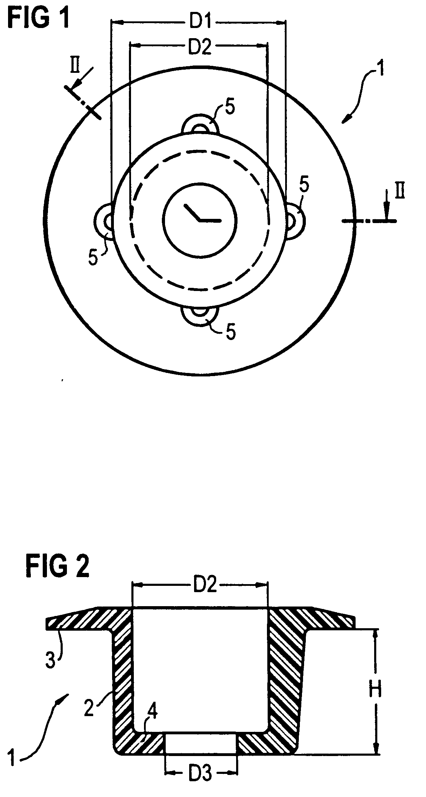

In der dazugehörenden Zeichnung zeigen
- Figur 1: eine Draufsicht auf ein Kunststoffteil und
- Figur 2: den in Figur 1 angegebenen Schnitt.

In der Zeichnung ist ein Kunststoffteil 1 dargestellt, das aus einem Zentralteil 2 besteht, das in das Befestigungsloch der Absorberplatte eingeführt ist. Der Außendurchmesser D1 dieses Zentralteils 2 ist dabei derart gewählt, daß das Kunststoffteil 1 in das Befestigungsloch eingeführt werden kann. An der oberen Seite des Kunststoffteils 1 ist eine Befestigungsplatte 3 angeformt, die auf der Oberfläche der Absorberplatte aufliegt.

Das Befestigungsteil 1 weist ferner einen Innendurchmesser D2 auf, der derart gewählt ist, daß der Kopf der Befestigungsschraube in das Befestigungsteil eingeführt werden kann und auf der Unterseite 4 beim Einschrauben anliegt. In der Unterseite 4 ist ferner ein Loch mit dem Durchmesser D 3 angeordnet, durch das der Schaft der Befestigungssschraube geführt ist.

An der Außenseite des Zentralteils 2 sind Rippen 5 angeformt, die einen klemmenden Sitz im Befestigungsloch der Absorberplatte gewährleisten und als Toleranzausgleich dienen.

Die Höhe H des Zentralteils 2 bemißt sich nach der Dicke der Ferritabsorberplatte und beträgt beispielsweise bei einer Absorberplatte der Größe 100 x 100 x 6 mm³ ebenfalls 6 mm.

Wahlweise ist auch nur ein Teil möglich, das sich an der minimal vorkommenden Dicke orientiert.

Bei ausreichend selbstklemmendem Sitz des Zentralteils 2 ist es auch möglich, die Befestigungsplatten 3 fortzulassen, so daß Kunstsstoffteil 1 und Kopf der Befestigungsschraube im Befestigungsloch der Absorberplatte versenkt sind.

## Patentansprüche

1. EMV-Meßraum, der mit auf einer Unterkonstruktion befestigten Absorberplatten ausgestaltet ist, und bei dem die Absorberplatten zumindest ein zentrales Befestigungsloch aufweisen und durch ein Befestigungsmittel lösbar mit der Unterkonstruktion verbunden sind,
**dadurch gekennzeichnet,**
daß in den Befestigungslöchern Kunststoffteile (1) angeordnet sind, in welchen jeweils eine Befestigungsschraube geführt ist, deren Kopf im Loch der Absorberplatte versenkt ist.

2. EMV-Meßraum nach Anspruch 1,
**dadurch gekennzeichnet,**
daß die Absorberplatten durch selbstschneidende Befestigungsschrauben gehaltert sind.

3. EMV-Meßraum nach Anspruch 1 oder 2,
**dadurch gekennzeichnet,**
daß das Kunststoffteil (1) als Klemmdübel ausgebildet ist und vollständig im Befestigungsloch der Absorberplatten angeordnet ist.
